(19) Europäisches Patentamt
European Patent Office
Office européen des brevets

(11) Numéro de publication: **0 081 412**
**B1**

(12) **FASCICULE DE BREVET EUROPEEN**

(45) Date de publication du fascicule du brevet: **29.01.86**

(51) Int. Cl.⁴: **G 01 R 33/032,** G 02 F 1/09

(21) Numéro de dépôt: **82402159.6**

(22) Date de dépôt: **26.11.82**

(54) **Tête de mesure pour magnétomètre.**

(30) Priorité: **04.12.81 FR 8122745**

(43) Date de publication de la demande:
**15.06.83 Bulletin 83/24**

(45) Mention de la délivrance du brevet:
**29.01.86 Bulletin 86/05**

(84) Etats contractants désignés:
**DE GB IT NL**

(56) Documents cités:
**EP-A-0 000 638**
**EP-A-0 046 298**
**FR-A-2 170 141**
**FR-A-2 355 299**
**GB-A-1 121 423**

**LASER FOCUS, mai 1970, pages 35-38, Newton, Mass., USA, A.A. JAECKLIN: "Measuring current at extra-high voltage"**

(73) Titulaire: **THOMSON-CSF**
**173, Boulevard Haussmann**
**F-75379 Paris Cedex 08 (FR)**

(72) Inventeur: **Doriath, Gérard**
**THOMSON-CSF SCPI 173, bld Haussmann**
**F-75379 Paris Cedex 08 (FR)**
Inventeur: **Gaudry, Roger**
**THOMSON-CSF SCPI 173, bld Haussmann**
**F-75379 Paris Cedex 08 (FR)**

(74) Mandataire: **Lepercque, Jean et al**
**THOMSON-CSF SCPI 173, Bld Haussmann**
**F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

EP 0 081 412 B1

**Description**

La présente invention se rapporte à une tête de mesure pour magnétomètre et à un magnétomètre comprenant une telle tête.

Dans la demande de brevet français FR—A—2 355 299, on a décrit un magnétomètre utilisant l'effet Faraday dans les couches minces de certains matériaux tels que les grenats d'yttrium et de fer couramment appelés YIG. Dans ce magnétomètre, on fait propager dans une couche mince d'une épaisseur de quelques micromètres un faisceau lumineux produit par un laser. Ce faisceau lumineux se propage de manière guidée selon un mode unique, transverse magnétique (TM) par exemple. Pour sélectionner ce mode, et compte tenu de la faible épaisseur de la couche, il faut faire pénétrer ce faisceau lumineux dans cette couche à l'aide d'un prisme de couplage. Sous l'effet du champ magnétique où est plongée la couche mince, le mode de propagation se convertit en partie en mode transverse électrique (TE). Pour extraire le faisceau lumineux de la couche, on utilise un prisme en matériau biréfringent qui délivre deux faisceaux lumineux séparés angulairement; l'un correspondant au mode TE, et l'autre au mode TM. L'intensité du faisceau correspondant au mode TE est une fonction de l'intensité du champ magnétique dans lequel est plongée la couche mince. Comme cette fonction n'est pas linéaire, on utilise pour effectuer la mesure une méthode de zéro qui consiste à compenser à l'intérieur de la couche mince le champ magnétique à mesurer par un champ antagoniste règlable produit par un bobinage. Pour détecter cette compensation, on superpose à ce champ continu un champ alternatif qui provoque l'apparition dans le faisceau correspondant au mode TE d'une modulation ne contenant, lorsque la compensation est réalisée, que des harmoniques pairs de la fréquence du champ alternatif dûs au fait que l'effet Faraday dépend de la valeur du champ magnétique et non pas de son sens. Lorsque la compensation n'est pas réalisée, on décèle l'apparition dans le faisceau modulé de composantes impaires, et notamment la composante fondamentale, et on utilise ces composantes pour commander un asservissement qui règle le champ de compensation pour obtenir la disparition de ces composantes impaires.

Bien que la couche de mesure soit de faible dimension, les organes annexes nécessaires pour l'utiliser sont beaucoup plus volumineux et d'un règlage délicat. De plus, la propagation monomode exige comme source lumineuse un laser de forte puissance et donc de grande taille. Enfin, la séparation angulaire des faisceaux provenant du prisme de sortie n'est pas très importante et nécessite que le détecteur soit placé suffisamment loin pour n'être excité que par le seul faisceau choisi.

Pour pallier les inconvénients de l'art connu, il est décrit dans la demande de brevet FR—A—2 471 608, un agencement particulier permettant l' obtention d'une tête de faible dimension pouvant mesurer le champ magnétique dans des espaces étroits et permettant de dresser des cartes de gradient magnétique. Pour ce faire, l'épaisseur de la couche de matériau magnétique est choisie de telle sorte qu'elle permette une propagation guidée multimode du faisceau et, en coopération avec les moyens d'émission du faisceau et les moyens de mesure de la rotation, l'entrée et la sortie du faisceau par la tranche de la couche.

Tout en conservant les avantages du dispositif objet de cette demande de brevet, la présente invention propose une structure de tête de mesure modifiée permettant simultanément d'augmenter la longueur utile de mesure, de simplifier le montage de la tête et de diminuer les dimensions de celle-ci.

Le premier but que se fixe l'invention peut être atteint en faisant effectuer à la lumière un aller et retour à l'intérieur de la couche mince de matériau magnétique, l'effet Faraday n'étant pas dépendant du sens de propagation de l'onde guidée, comme dans l'article paru dans Laser Focus en mai 1970, aux pages 35—38, par A. A. Jaecklin et intituté: "Measuring current at extra-high voltage", publié à Newton, Mass., U.S.A.

Le deuxième but peut être atteint en dissociant la partie sonde mesure proprement dite, essentiellement constituée par la couche mince de matériau magnétique, des organes d'émission-réception de lumière. Ces deux sous-ensembles sont couplés par une fibre optique éliminant notamment les difficultés de positionnement précis de l'organe de détection constitué d'une une photodiode.

Le troisième but peut être atteint notamment en remplaçant les aimants permanents ou moyens analogues induisant un champ magnétique transverse dans la couche de matériau magnétique par des électrodes disposées sur cette couche.

L'invention a donc pour objet une tête de mesure pour magnétomètre, du type comprenant des moyens pour émettre un faisceau de lumière polarisée linéairement, une couche plane d'un matériau magnétique permettant une propagation guidée de ce faisceau en son sein parallèlement aux faces planes de ce matériau et de faire tourner sa direction de polarisation pendant sa propagation, des moyens pour réfléchir le faisceau guidé de manière à lui faire effectuer un aller et retour au sein de la couche de matériau magnétique, des moyens pour séparer le faisceau entrant dans la couche du faisceau sortant après l'aller et retour, des moyens pour mesurer la rotation de polarisation subie par la lumière dans son trajet dans la couche, et des moyens pour induire dans cette couche un champ magnétique de polarisation parallèle au plan de la couche et perpendiculaire à la direction de propagation du faisceau de lumière, caractérisé en ce qu'il comprend en outre une fibre optique pour guider sur un trajet commun les faisceaux entrant dans et sortant de la couche entre les moyens de séparation de ces faisceaux et la tranche de la

couche, et que les moyens d'induction du champ magnétique de polarisation comprennent une électrode plane en matériau électriquement conducteur recouvrant complètement la couche de matériau magnétique et séparé de celle-ci par une couche isolante en matériau diélectrique et des moyens pour établir un courant continu dans cette électrode circulant d'une extrémité à l'autre suivant une direction parallèle à la direction de propagation du faisceau.

L'invention a également pour objet une tête de mesure pour magnétomètre, du type comprenant des moyens pour émettre un faisceau de lumière polarisée linéairement, une couche plane d'un matériau magnétique permettant une propagation guidée de ce faisceau en son sein parallèlement aux faces planes de ce matériau et de faire tourner sa direction de polarisation pendant sa propagation, des moyens pour réfléchir le faisceau guidé de manière à lui faire effectuer un aller et retour au sein de la couche de matériau magnétique, des moyens pour séparer le faisceau entrant dans la couche du faisceau sortant après l'aller et retour, des moyens pour mesurer la rotation de polarisation subie par la lumière dans son trajet dans la couche, et des moyens pour induire dans cette couche un champ magnétique de polarisation parallèle au plan de la couche et perpendiculaire à la direction de propagation du faisceau de lumière, caractérisé en ce qu'il comprend en outre une fibre optique pour guider sur un trajet commun les faisceaux entrant dans et sortant de la couche entre les moyens de séparation de ces faisceaux et la tranche de la couche, et que les moyens d'induction du champ magnétique de polarisation comprennent deux électrodes planes en matériau électriquement conducteur disposées sur la couche de matériau magnétique de part et d'autre d'un axe médian parallèle à la direction de propagation du faisceau de manière à laisser découverte une bande centrale de la couche du matériau magnétique formant guide d'onde pour ledit faisceau, et des moyens pour établir un courant continu dans ces électrodes circulant d'une extrémité à l'autre de celles-ci suivant une direction parallèle à la direction de propagation du faisceau.

L'invention sera mieux comprise et d'autres caractéristiques apparaîtront à l'aide de la description qui suit, en référence aux figures annexées parmi lesquelles:

— la figure 1, qui représente une vue écorchée d'une tête de mesure selon la demande de brevet FR—A—2 471 608.
— la figure 2 illustre la configuration d'une tête de mesure comportant certaines caractéristiques de l'invention.
— la figure 3 est un exemple de réalisation pratique d'un sous-ensemble particulier de cette tête.
— les figures 4 et 5 représentent les deux variantes de réalisation d'un élément de ce sous-ensemble selon l'invention.
— la figure 6 est un schéma électrique simplifié des circuits électriques associés à la tête de mesure.

Il est tout d'abord utile de rappeler l'agencement de la tête magnétique selon la demande de brevet FR—A—2 471 608. Cet agencement est représenté sur la figure 1.

La tête de magnétomètre représentée sur cette figure comprend une plaquette en céramique 101 qui sert de support aux organes actifs de la tête. Sur cette plaquette, en son milieu, on a collé une plaquette plus petite 102 taillée dans un grenat de gadolinium et de gallium dit GGG dont les dimensions longueur par largeur et par épaisseur sont d'environ 10×3×0,7 mm. Sur la surface de GGG on a fait pousser par épitaxie une couche 103 relativement épaisse de YIG répondant sensiblement à la composition

$$Gd_{0,45}Y_{2,55}Ga_{0,9}Fe_{4,1}O_{12}.$$

L'épaisseur obtenue peut être comprise entre 5 et 110 microns et une valeur typique est de 20 microns.

Une telle épaisseur de YIG permet de faire propager la lumière de manière guidée mais multimode, et dans ces conditions l'effet Faraday dû au champ magnétique se manifeste uniquement par une rotation du plan de polarisation de la lumière et non plus par une conversion du mode TM en mode TE. Ceci permet de coupler le faisceau lumineux par les faces terminales de la couche de YIG.

Néanmoins pour obtenir ce couplage, il faut que ces surfaces d'entrée et de sortie soient les plus parfaites possibles. Il n'est généralement pas possible de trouver un axe de clivage en raison de l'inhomogénéité du matériau. On est alors amené à procéder à un polissage de ces faces.

Différents procédés connus peuvent être mis en oeuvre et parmi ceux-ci, le procédé décrit en détail dans la demande de brevet principal qu'il est inutile de rappeler dans le cadre de la présente addition.

La source lumineuse est formée d'une diode laser 104 fixée sur la plaquette 101 de telle manière que sa jonction par la tranche de laquelle sort le faisceau lumineux de lumière cohérente soit située sensiblement au centre de la couche de YIG. La surface émissive d'une telle diode a sensiblement une épaisseur de 0,2 micromètres et une largeur de 15 micromètres. Cette diode est alimentée par une tension électrique VE convenable par l'intermédiaire de deux connexions d'entrée.

Entre la diode laser et le substrat portant la couche de YIG, on a placé un polariseur 105 qui permet de polariser linéairement la lumière émise par la diode laser dans la couche de YIG. Ce polariseur est par exemple découpé dans un film polarisant d'un type couramment utilisé n optique. Son épaisseur est telle qu'il ne perturbe pas le couplage entre la diode émettrice et la couche YIG pourvu qu'on prenne bien soin de pincer modérément le polariseur entre la diode et

la plaquette 102. Une rainure 106 pratiquée dans la plaquette 101 permet de faciliter le montage du polariseur.

A l'autre extrémité de la plaquette 102, on a placé un analyseur 107 semblable au polariseur 105 mais croisé par rapport à lui et immobilisé pour le montage dans une autre fente 108.

Cet analyseur et légèrement pincé entre la plaquette 102 et une photodiode détectrice 109. Cette photodiode est par exemple du type au germanium soumise à une polarisation inverse d'une dizaine de volts et sa surface active set réalisée sous la forme sensiblement d'un rectangle pour capter le maximum de lumière en sortie de la couche YIG. On recueille dans ces conditions un signal électrique de sortie VS représentatif de l'énergie lumineuse détectée.

La plaquette 101 et l'ensemble des éléments actifs qu'elle supporte sont placés à l'intérieur d'un solénoïde 110 qui permet d'appliquer le champ magnétique de compensation et le champ alternatif de mesure.

Pour la mesure de l'effet Faraday dans la couche YIG, il est nécessaire que l'aimantation initiale de cette couche soit transverse par rapport à la direction de la propagation de la lumière dans celle-ci. Pour cela, il est nécessaire d'utiliser des moyens qui induisent ce champ transverse avec une valeur d'environ $10^{-2}$ Ampère-tour/mètre. Ces moyens sont par exemple des aimants permanents représentés sur la figure 1 sous la forme des blocs 111 et 112. On peut également utiliser, si on veut optimiser la valeur de ce champ selon la sensibilité à obtenir, des bobines de Helmoltz placées à la place de ces aimants 111 et 112.

Bien que la structure adoptée permette notamment d'obtenir une tête de mesure performante et de très faibles dimensions, ces dimensions, hors tout, étant de l'ordre de la plus grande dimension de la plaquette 101, c'est-à-dire d'environ 1 cm, il est possible tout en conservant les avantages de cet agencement simultanément d'améliorer encore ses performances et d'en réduire les dimensions.

Pour ce faire, l'invention propose une structure dans laquelle les éléments sont agencés différemment de ce qui vient d'être décrit.

La figure 2 illustre schématiquement un agencement comportant certaines caractéristiques de la présente invention. Les éléments communs à la tête de mesure qui viennent d'être rappelés en relation avec la description de la figure 1 portent les mêmes références et ne seront pas décrits à nouveau de façon détaillée.

Une caractéristique importante est la répartition en deux sous-ensembles autonomes des éléments constitutifs de la tête de mesure, ces deux sous-ensembles étant couplés par une fibre optique f, monomode ou multimode.

Le premier sous-ensemble I, comprend les organes d'émission-réception d'énergie lumineuse. Outre un laser 104 et un détecteur 109, par exemple une photodiode, il comprend des moyens 100 pour la polarisation, la séparation des polarisations et l'analyse de la lumière transmise et reçue à/de la fibre optique f qui lui est couplée.

Dans une variante préférentielle de l'invention, les moyens 100 peuvent être réalisés à partir d'un cube consitué de deux prismes collés en matériau réfringent. La surface de séparation, consituée par l'hypothénuse des deux prismes, est traitée de façon à être séparatrice de polarisation. Cet élément présente un axe optique préférentiel. Les rayons incidents sont transmis avec une polarisation linéaire parallèle à cet axe et injectés dans la fibre optique f. Les rayons provenant de la fibre f sont divisés en deux composantes de direction de polarisation orthogonales. La composante ayant une direction de polarisation orthogonale à l'axe optique préférentiel est réfléchie en totalité suivant la direction d'émergence orthogonale à la direction d'incidence, c'est-à-dire vers le détecteur 109. Les faces du cube peuvent en outre avoir subi un traitement de surface pour éviter les reflets parasites. Ce traitement est connu de l'homme de métier.

D'autres éléments optiques peuvent être utilisés dans le cadre de l'invention, c'est notamment le cas de certains polariseurs biréfringents tels que le prisme de GLAN. Il faut cependant sélectionner de préférence un polariseur transmettant les rayons incidents d'une première direction de polarisation sans modification et réfléchissant de façon totale les rayons de direction de polarisation orthogonale à la direction précédente.

Enfin plus généralement, si l'élément optique assurant la séparation de polarisation ne polarise pas les rayons, une paire d'éléments polariseur et analysur peut être utilisée, par exemple des éléments analogues à ceux (105, 107) mis en oeuvre dans la tête de mesure décrite en relation avec la figure 1.

Enfin certains lasers semi-conducteurs émettent un faisceau de lumière déjà polarisée. Il sera nécessaire alors de faire coïncider la direction de polarisation avec l'axe optique préférentiel du cube 100 ou de tout autre élément en faisant fonction.

En particulier dans ce cas, il est également souhaitable d'éviter la réinjection de la composante n'ayant pas subi de rotation dans la couche active 103. Pour ce faire, dans une variante préférentielle mais non limitative, on intercale entre la source laser 104 et le cuve 100, un isolateur 1000 comprenant un élément 1001 faisant tourner la polarisation préférentiellement de π/4 radians et comportant un polariseur 1002 sur la face d'entrée de même axe de polarisation que la direction de polarisation de la lumière émise par la source laser 104. Le polariseur transmet donc intégralement la lumière émise. L'élément 1001 peut être constitué par un bloc en matériau YIG faisant tourner la polarisation par effet Faraday et accolé au bloc 100.

L'axe optique privilégié du cube 100 doit être parallèle à la nouvelle polarisation de la lumière telle que transmise par l'élément isolateur. En retour, la lumière n'ayant pas subie de rotation et

retransmise par le cub 100 au bloc 1000 voit son axe de polarisation tourner à nouveau de π/4 radians. Il s'ensuit que cette composante parasite est éliminée par le polariseur 1002.

Le second sous-ensemble II, constitue la sonde de mesure proprement dite.

Une première variante de réalisation pratique de ce sous-ensemble est illustrée par la figure 3. Il comprend les éléments précédemment décrits plaquette support 101, plaquette GGG 102, couche de matériau actif 103, solénoïde 110, ainsi que des moyens 111 et 112 pour appliquer un champ magnétique transverse au sein de la couche 103. Ces moyens, comme précédemment indiqué, peuvent être constitués par deux aimants permanents.

Dans le cadre de la présente invention, la plaquette intermédiaire 102 peut être prolongée sur le support et comporter un Vé de référence dans lequel est positionnée la fibre optique f pour assurer un bon couplage optique entre celle-ci et la couche de matériau actif 103. Selon un aspect important de l'invention, le couplage optique direct avec la tranche de la couche de matériau 103, sans éléments optiques intermédiaire tels qu'analyseur ou polariseur, lentilles etc.... Ceci est permis par l'architecture adaptée. Des moyens de scellement, non représentés, sont également mis en oeuvre pour fixer la fibre après positionnement. Un liquide d'indice peut également être utilisé et introduit entre la tranche et la fibre optique.

Le positionnement peut enfin être assuré par des moyens solidaires du support 101 et non de la plaquette 102 comme illustré.

Une autre particulairté importante est consituée par la présence d'un miroir M sur la face de la couche 103 opposée à la face de couplage avec la fibre optique f.

Ce miroir M peut être réalisé simplement sous la forme d'une métallisation de la tranche 103. Le fonctionnement global de la tête de mesure est identique à celui de la tête de mesure décrite en relation avec la figure 1. Dans ces conditions, si on se reporte à nouveau à la figure 2, la longueur utile à prendre en compte n'est pas la longueur simple 1 de la couche 103. L'effet Faraday étant indépendant du sens de propagation de l'onde lumineuse, du fait de l'aller et retour de l'onde dû à la réflexion sur le miroir M, c'est la longueur double 21 qui intervient. Pour une sensibilité égale, la couche 103 (et également dans des proportions analogues la plaquette 101) peut être réduite de moitié. Dans le cas contraire, à dimensions égales de la couche 103, la sensibilité peut être doublée.

L'onde lumineuse subit donc par effet Faraday une rotation de polarisation, d'amplitude double de celle de la tête de mesure précédemment décrite, avant d'être réinjectée dans la fibre optique f.

En sortie de la fibre f, l'onde incidente va être divisée en deux composantes de polarisations orthogonales entre elles. Seules la composante de direction de polarisation orthogonale à l'axe optique préférentiel du cube 100 va être réfléchie vers le détecteur 109.

Cette composante est représentative de l'amplitude de la rotation due à l'effet Faraday.

Outre les avantages qui viennent d'être énumérés, l'agencement de la tête de mesure conformément à l'invention permet une construction particulièrement simple et compacte de la partie sonde de mesure proprement dite (sous-ensemble II) de la tête de mesure: seule la fibre optique est à positionner par rapport à la couche 103. En outre les organes d'émission-réception de lumière peuvent être rendus fixes et les seules liaisons à assurer sont l'alimentation électrique du solénoïde 110 et le couplage optique à l'aide d'une fibre f.

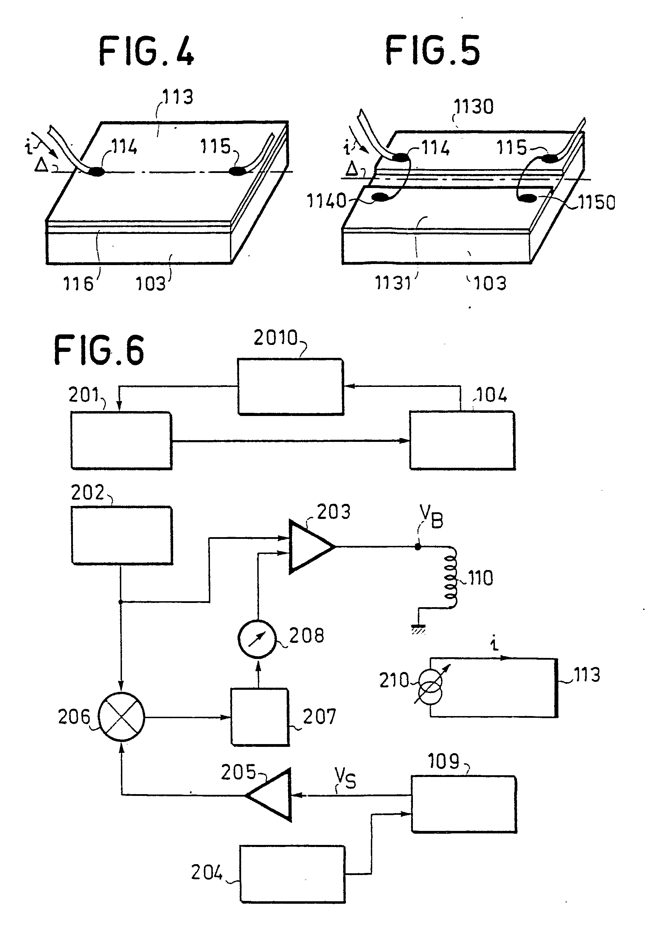

Les deux variantes de réalisation de la présente inventions illustrées par les figures 4 et 5, permettent de diminuer les dimensions du sous-ensemble sonde de mesure II. En effet si on recouvre la surface de la couche 103 par une électrode parcourue par un courant électrique continu i suivant une direction essentiellement parallèle à la direction de propagation de l'onde guidée, il s'ensuit, conformément aux lois de l'électromagnétisme, la génération d'un champ magnétique continu dont les lignes de champs au sein du matériau de la couche 103 sont sensiblement parallèles au plan principal de cette couche et orthogonales à la direction de propagation.

Selon une première variante de réalisation, illustrée par la figure 4, cette électrode 113 recouvre entièrement la surface du matériau 103. Elle peut être consituée par une métallisation de la face supérieure de la couche.

Des prises de contact électrique 114 et 115 avec des fils de liaison extérieurs dans lesquels circule le courant i sont réalisés aux deux extrémités de la couche 103 dans des régions voisines d'un axe Δ parallèle à la direction de propagation de l'onde et délimitant cette couche en deux parties égales. Pour éviter un affaiblissement du mode TM par intéraction entre l'onde guidée et la plaque métallique 113 ainsi créée, il est prévu une couche intermédiaire 116 d'un matériau diélectrique de faible épaisseur, typiquement 1 micromètre.

Pour éviter cette disposition, selon une seconde variante de réalisation illustrée par la figure 5, l'électrode est scindée en deux plages 1130 et 1131 laissant libre la zone centrale dans laquelle se propage essentiellement l'onde guidée. Il n'y a donc plus d'intéraction et la couche de matériau diélectrique devient inutile. Des connexions supplémentaires 1140 et 1150 assurent une continuité électrique entre les deux plages de l'électrode.

Dans un exemple de réalisation typique, avec une couche de matériau 103 épaisse de 30 micromètres, un courant i d'environ 25 mA est nécessaire pour créer un champ magnétique transverse de l'ordre de grandeur indiqué précédemment: $10^{-2}$ Ampère-tour/mètre.

Les circuits électroniques annexes associés à la tête de mesure selon les variantes de réalisations qui viennent d'être décrites différent peu de ceux

mis en oeuvre dans le cadre de la demande de brevet FR—A—2 471 608 et vont être brièvement rappelés dans ce qui suit. La figure 6 illustre un schéma électrique simplifié de ces circuits qui peuvent être localisés dans un boitier commun aux organes d'émission-réception: sous-ensemble I (figure 2).

Ces circuits comprenant tout d'abord une source d'alimentation stabilisée 201 qui fournit l'énergie nécessaire à l'alimentation de la source laser 104. S'il s'agit d'un laser à semi-conducteur il est également prévu des circuits d'asservissement 2010 contrôlant l'énergie émise par la source d'alimentation 201, ce type de laser étant très sensible à la température. Ces circuits sont biens connus de l'homme de métier. Pour une diode laser émettant dans l'infrarouge sous une longueur d'onde de 1,3 micromètres par exemple, une puissance lumineuse de 4 milliwatts est obtenue avec une intensité d'alimentation de 200 milliampères.

Un oscillateur 202 fournit un signal à fréquence relativement élevée, 100 Khz par exemple. Ce signal est additionné à un signal continu ou faiblement variable dans un amplificateur 203 qui délivre une tension VB appliquée au solénoïde 110.

Un générateur de tension de polarisation 204 permet de délivrer la tension de polarisation de la photodiode 109 qui, en détectant le faisceau lumineux, délivre le signal VS. Ce signal VS est amplifié dans un amplificateur sélectif 205 centré sur la fréquence du signal fourni par l'oscillateur 202.

Le signal en sortie de cet amplificateur 205 est comparé avec le signal en sortie de l'oscillateur 202 dans un détecteur synchrone qui mesure à la fois l'amplitude du signal à la fréquence fondamentale et son changement de phase lors du passage par zéro de cette amplitude. Ce détecteur délivre un signal d'erreur.

Ce signal d'erreur est appliqué à un servomécanisme 207 qui comprend par exemple un générateur de tension et un filtre correcteur qui permettent de générer une tension de contre-réaction qui, appliquée par l'intermédiaire de l'amplificateur 203 au solénoïde 110, tend à annuler le signal d'erreur en sortie du comparateur 210 en compensant le champ magnétique à mesurer dans l'intérieur de la couche YIG 103.

Pour obtenir la valeur du champ magnétique à mesurer, on mesure la valeur du champ magnétique de compensation par l'intermédiaire de la valeur du signal qui le génère et qui est appliqué par le servomécanisme 207 à l'amplificateur 203. Pour cela, un appareil de mesure 208 est inséré entre le servomécanisme 207 et l'amplificateur 203.

Dans les variantes de réalisations selon l'invention illustrées par les figures 4 et 5, les circuits de commande comportent en outre une source de courant 210 pour faire circuler dans l'électrode 113 (ou les électrodes 1130 et 1131) le courant i nécessaire à la création du champ magnétique transverse au sein du matériau 103.

**Revendications**

1. Tête de mesure pour magnétomètre, du type comprenant des moyens (104) pour émettre un faisceau de lumière polarisée linéairement, une couche (103) plane d'un matériau magnétique permettant une propagation guidée de ce faisceau en son sein parallèlement aux faces planes de ce matériau et de faire tourner sa direction de polarisation pendant sa propagation, des moyens (M) pour réfléchir le faisceau guidé de manière à lui faire effectuer un aller et retour au sein de la couche de matériau magnétique, des moyens (100) pour séparer le faisceau entrant dans la couche du faisceau sortant après l'aller et retour, des moyens (109) pour mesurer la rotation de polarisation subie par la lumière dans son trajet dans la couche, et des moyens (111, 112) pour induire dans cette couche un champ magnétique de polarisation parallèle au plan de la couche et perpendiculaire à la direction de propagation du faisceau de lumière, caractérisé en ce qu'il comprend en outre une fibre optique (f) pour guider sur un trajet commun les faisceaux entrant dans et sortant de la couche entre les moyens (100) de séparation de ces faisceaux et la tranche de la couche, et que les moyens d'induction du champ magnétique de polarisation comprennent une électrode (113) plane en matériau électriquement conducteur recouvrant complètement la couche de matériau magnétique (103) et séparé de celle-ci par une couche isolante (116) en matériau diélectrique et des moyens (114, 115, 2010) pour établir un courant continu dans cette électrode circulant d'une extrémité à l'autre suivant une direction parallèle à la direction de propagation du faisceau.

2. Tête de mesure pour magnétomètre, du type comprenant des moyens (104) pour émettre un faisceau de lumière polarisée linéairement, une couche (103) plane d'un matériau magnétique permettant une propagation guidée de ce faisceau en son sein parallèlement aux faces planes de ce matériau et de faire tourner sa direction de polarisation pendant sa propagation, des moyens (M) pour réfléchir le faisceau guidé de manière à lui faire effectuer un aller et retour au sein de la couche de matériau magnétique, des moyens (100) pour séparer le faisceau entrant dans la couche du faisceau sortant après l'aller et retour, des moyens (100) pour mesurer la rotation de polarisation subie par la lumière dans son trajet dans la couche, et des moyens (111, 112) pour induire dans cette couche un champ magnétique de polarisation parallèle au plan de la couche et perpendiculaire à la direction de propagation du faisceau de lumière, caractérisé en ce qu'il comprend en outre une fibre optique (f) pour guider sur un trajet commun les faisceaux entrant dans et sortant de la couche entre les moyens (100) de séparation de ces faisceaux et la tranche de la couche, et que les moyens d'induction du

champ magnétique de polarisation comprennent deux électrodes (1130, 1131) planes en matériau électriquement conducteur disposées sur la couche de matériau magnétique de part et d'autre d'un axe médian parallèle à la direction de propagation du faisceau de manière à laisser découverte une bande centrale de la couche du matériau magnétique (103) formant guide d'onde pour ledit faisceau, et des moyens (114, 1140, 115, 1150, 210) pour établir un courant continu dans ces électrodes circulant d'une extrémité à l'autre de celles-ci suivant une direction parallèle à la direction de propagation du faisceau.

3. Tête de mesure selon une quelconque des revendications 1 et 2, caractérisée en ce que les moyens de séparation (100) comprennent un cube réalisé par l'accolement de deux prismes droits en matériau réfringent et dont la surface de séparation constituée par l'hypothénuse des deux prismes est traitée de façon à être séparatrice de polarisation.

4. Tête de mesure selon une quelconque des revendications 1 et 2, caractérisée en ce que les moyens de séparation (100) comprennent un prisme de GLAN.

5. Tête de mesure selon l'une quelconque des revendications 1 à 4, caractérisée en ce que les moyens réfléchissant le faisceau guidé sont constitués par un miroir (M) réalisé par métallisation de la tranche de la couche (103) de matériau magnétique.

6. Tête de mesure selon l'une quelconque des revendications 1 à 5, caractérisée en ce que le matériau magnétique (103) est un grenat d'yttrium et de fer épitaxié sur un grenat de gadolinium et de gallium avec une épaisseur comprise entre 5 micromètres et 110 micromètres.

7. Tête de mesure selon l'une quelconque des revendications 1 à 6 caractérisée en ce que la longueur d'onde de la lumière polarisée est sensiblement de 1,3 micromètre.

**Patentansprüche**

1. Meßkopf für Magnetometer, vom Typ mit Mitteln (104) zum Aussenden eines Bündels aus linear polarisiertem Licht, einer ebenen Schicht (103) aus einem magnetischen Material, welches eine gelenkte Ausbreitung dieses Bündels in seinem Inneren parallel zu den ebenen Flächen dieses Materials sowie eine Drehung seiner Polarisationsrichtung während der Ausbreitung gestattet, Mitteln (M) zum Reflektieren des gelenkten Bündels derart, daß es einen Hin- und Rücklauf im Inneren der magnetischen Schicht ausführt, Mitteln (100) zum Trennen des in die Schicht eintretenden Bündels von dem nach dem Hin- und Rücklauf austretenden Bündel, Mitteln (109) zur Messung der Polarisationsdrehung, welche das Licht auf seiner Bahn in der Schicht erfahren hat, und Mitteln (111, 112) zur Einleitung eines magnetischen Polarisationsfeldes in diese Schicht parallel zur Ebene der Schicht und senkrecht zur Ausbreitungsrichtung des Lichtbündels, dadurch gekennzeichnet, daß er ferner eine optische Faser (f) umfaßt, um das in die Schicht eintretende Bündel und das aus dieser austretende Bündel auf einer gemeinsamen Bahn zwischen den Mitteln (100) zur Trennung dieser Bündel und der Schmalseite der Schicht zu führen, und daß die Mittel zur Einleitung des magnetischen Polarisationsfeldes eine ebene Elektrode (113) aus einem elektrische leitfähigen Material umfassen, welche die Schicht aus magnetischem Material (103) vollständig bedeckt und von dieser durch eine Isolierschicht (116) aus dielektrischem Material gebildet ist, sowie Mittel (114, 115, 2010) zur Herstellung eines Gleichstromes in dieser Elektrode umfassen, welcher von einem Ende zum anderen in einer Richtung parallel zur Ausbreitungsrichtung des Bündels verläuft.

2. Meßkopf für Magnetometer, vom Typ mit Mitteln (104) zum Aussenden eines Bündels aus linear polarisiertem Licht, einer ebenen Schicht (103) aus einem magnetischen Material, welches eine geführte Ausbreitung dieses Bündels in seinem Inneren parallel zu den ebenen Flächen dieses Materials sowie eine Drehung seiner Polarisationsrichtung während seiner Ausbreitung gestattet, Mitteln (M) zum Reflektieren des geführten Bündels derart, daß es einen Hin- und Rücklauf im Inneren der Schicht aus magnetischem Material ausführt, Mitteln (100) zum Trennen des in die Schicht eintretenden Bündels von dem nach dem Hin- und Rücklauf austretenden Bündel, Mitteln (109) zur Messung der Polarisationsdrehung, die das Licht während seiner Bahn in der Schicht erfahren hat, und Mitteln (111, 112), um in diese Schicht ein magnetisches Polarisationsfeld parallel zur Ebene der Schicht und senkrecht zu der Ausbreitungsrichtung des Lichtbündels einzuleiten, dadurch gekennzeichnet, daß er ferner eine optische Faser (f) umfaßt, um das in die Schicht eintretende Bündel und das aus dieser austretende Bündel auf einem gemeinsamen Weg zwischen den Mitteln (100) zur Trennung dieser beiden Bündel und der Schmalseite der Schicht zu führen, und daß die Mittel zur Einleitung des magnetischen Polarisationsfeldes zwei ebene Elektroden (1130, 1131) aus elektrisch leitfähigem Material umfassen, welche auf der Schicht aus magnetischem Material auf der einen und anderen Seite einer Mittelachse angeordnet sind, welche parallel zur Ausbreitungsrichtung des Bündels ist, dergestalt, daß ein zentraler Streifen der Schicht aus magnetischem Mateiral (103) freigelassen wird, welcher einen Wellenleiter für das genannte Bündel bildet, sowie Mittel (114, 1140, 115, 1150, 210) umfassen, um einen Gleichstrom in diesen Elektroden zu erzeugen, welcher von einem Ende zum anderen derselben in einer Richtung parallel zur Ausbreitungsrichtung des Bündels verläuft.

3. Meßkopf nach einem der Ansprüche 1 und 2, dadurch gekennzeichnet, daß die Trennmittel (100) einen Würfel umfassen, der durch Aneinandersetzen von zwei rechtwinkligen Prismen aus lichtbrechendem Material gebildet

ist und dessen durch die Hypotenuse der zwei Prismen gebildete Trennfläche derart behandelt ist, daß sie eine Polarisationstrennung bewirkt.

4. Meßkopf nach einem der Ansprüche 1 und 2, dadurch gekennzeichnet, daß die Trennmittel (100) ein GLAN-Prisma umfassen.

5. Meßkopf nach einem der Ansprüche 1 bis 4, dadurch gekennzeichnet, daß die das gelenkte Bündel reflektierenden Mittel durch einen Spiegel (M) gebildet sind, welcher durch die Metallisierung der Schmalseite der Schicht (103) aus magnetischem Material gebildet ist.

6. Meßkopf nach einem der Ansprüche 1 bis 5, dadurch gekennzeichnet, daß das magnetische Material ein Yttrium- und Eisen-Granat ist, welcher epitaktisch auf einem Gadolinium- und Gallium-Granat mit einer Dicke zwischen 5 Mikrometern und 110 Mikrometern aufgebracht ist.

7. Meßkopf nach einem der Ansprüche 1 bis 6, dadurch gekennzeichnet, daß die Wellenlänge des polarisierten Lichtes im wesentlichen 1,3 Mikrometer beträgt.

**Claims**

1. Magnetometer measuring head of the type comprising means (104) for emitting a beam of linearly polarized light, a planar layer (13) of a magnetic material permitting a guided propagation of said beam in its interior parallel to the planar faces of said material and a rotation of its polarization direction during its propagation, means (M) for reflecting the guided beam so that it effects a to and fro travel in the interior of the magnetic layer, means (100) for separating the beam entering the layer from the beam emerging after the to and fro travel, means (109) for measuring the polarization rotation undergone by the light on its path in the layer, and means (111, 112) for inducing in said layer a magnetic polarization field parallel to the plane of the layer and perpendicular to the propagation direction of the light beam, characterized in that it further includes an optical fiber (f) for guiding on a common path the beams entering and emerging from the layer between the means (100) for separating said beams and the narrow side of the layer, and that the means for induction of the magnetic polarization field comprise a planar electrode (113) of an electrically conductive material covering completely the layer of magnetic material (103) and separated from the latter by an insulating layer (116) of dielectric material, and means (114, 115, 2010) for establishing a direct current in said electrode running from one end to the other in a direction parallel to the propagation direction of the beam.

2. Magnetometer measuring head of the type comprising means (104) for emitting a beam of linearly polarized light, a planar layer (13) of a magnetic material permitting a guided propagation of said beam in its interior parallel to the planar faces of said material and a rotation of its polarization direction during its propagation, means (M) for reflecting the guided beam so that it effects a to and fro travel in the interior of the magnetic layer, means (100) for separating the beam entering the layer from the beam emerging after the to and fro travel, means (109) for measuring the polarization rotation undergone by the light on its path in the layer, and means (111, 112) for inducing in said layer a magnetic polarization field parallel to the plane of the layer and perpendicular to the propagation direction of the light beam, characterized in that it further includes an optical fiber (f) for guiding on a common path the beams entering and emerging from the layer between the means (100) for separating said beams and the narrow side of the layer, and that the means for induction of the magnetic polarization field comprise two planar electrodes (1130, 1131) of electrically conductive material disposed on the layer of magnetic material on either side of a centre axis parallel to the propagation direction of the beam in a manner to leave uncovered a central strip of the layer of magnetic material (103) forming a waveguide for said beam, and means (114, 1140, 115, 1150, 210) for establishing a direct current in said electrodes running from one end to the other thereof in a direction parallel to the propagation direction of the beam.

3. Measuring head according to any one of claims 1 and 2, characterized in that the separation means (100) comprise a cube formed by placing together two rectangular prisms of refractive material, the separation surface of which formed by the hypotenuse of the two prisms is treated such that it effects a polarization separation.

4. Measuring head according to any one of claims 1 and 2, characterized in that the separation means (100) comprise a GLAN prism.

5. Measuring head according to any one of claims 1 to 4, characterized in that the means reflecting the guided beam are formed by a mirror (M) formed by metallization of the narrow side of the layer (103) of magnetic material.

6. Measuring head according to any one of claims 1 to 5, characterized in that the magnetic material is a yttrium and iron garnet applied epitaxially to a gadolinium and gallium garnet having a thickness between 5 micrometers and 110 micrometers.

7. Measuring head according to any one of claims 1 to 6, characterized in that the wavelength of the polarized light is substantially 1.3 micrometers.

FIG.1

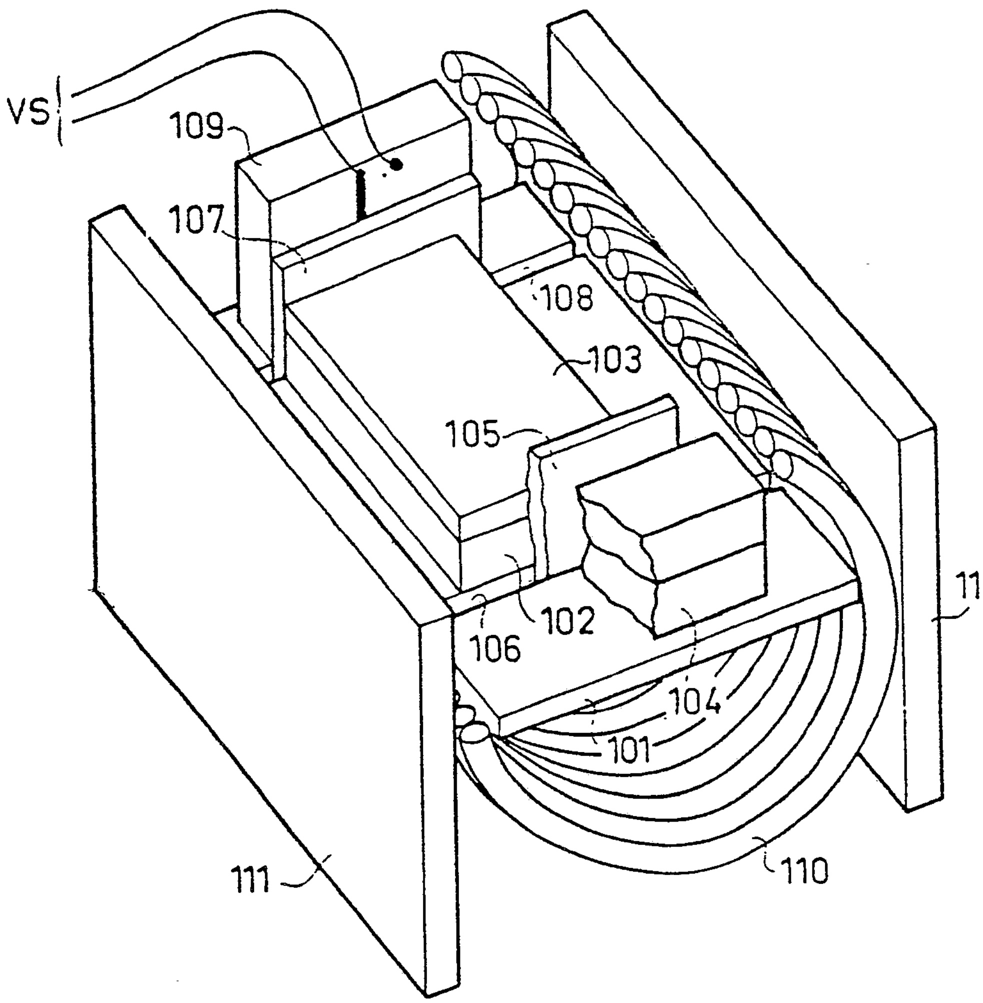

FIG.2

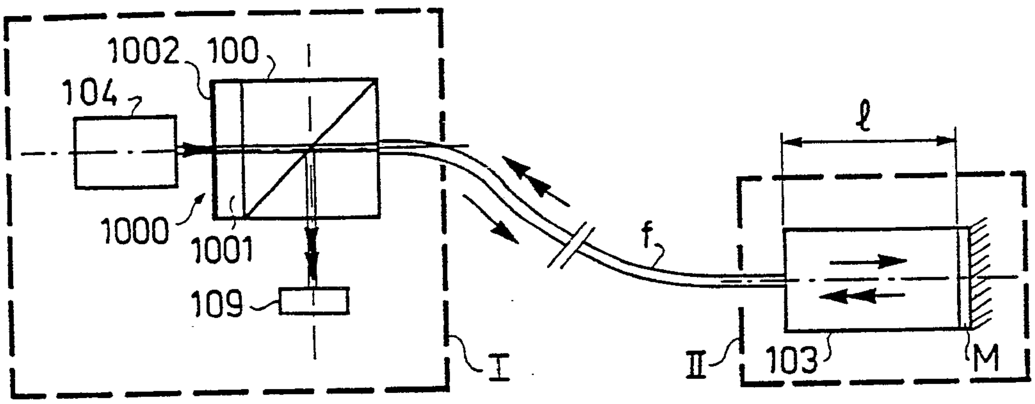
1002
100
104
1000
1001
109
I
f
ℓ
II
103
M

FIG.3

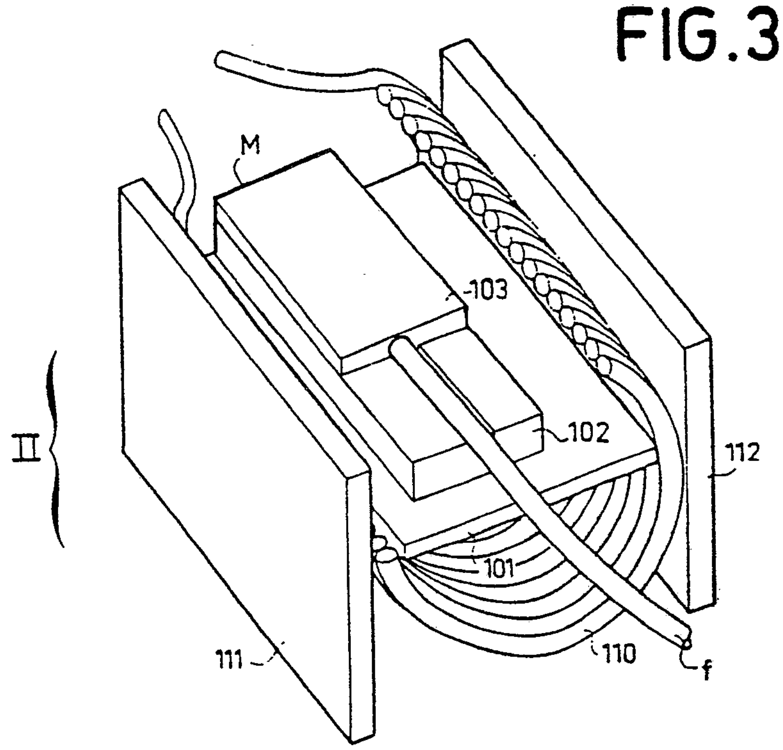
M
103
102
II
112
101
111
110
f

FIG. 4

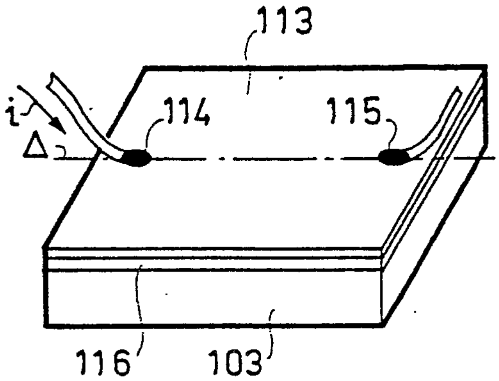


FIG. 5

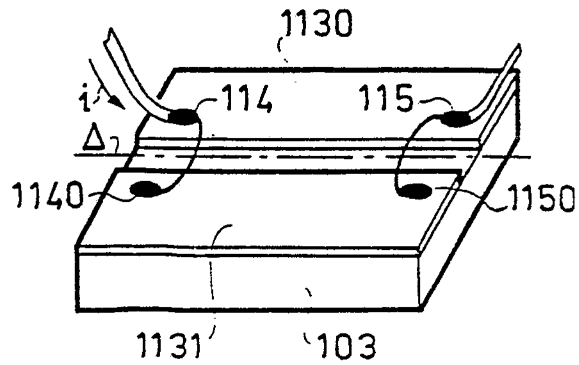


FIG. 6